# EUROPÄISCHE PATENTSCHRIFT

(11) **EP 0 766 375 B1**
(45) Veröffentlichungstag und Bekanntmachung des Hinweises auf die Patenterteilung: **22.03.2000**
(21) Anmeldenummer: 96112482.3
(22) Anmeldetag: 02.08.1996
(51) Int. Cl.: H03B 5/12, H03C 3/08

(54) **Spannungsgesteuerter Oszillator**
Voltage controlled oscillator
Oscillateur commandé en tension

(30) Priorität: 26.09.1995 DE 19535695
(43) Veröffentlichungstag der Anmeldung: 02.04.1997
(73) Patentinhaber: ROBERT BOSCH GMBH, 70442 Stuttgart (DE)
(72) Erfinder: Von Spreckelsen, Michael, 12209 Berlin (DE)

(56) Entgegenhaltungen:
- EP-A- 0 082 473
- US-A- 3 984 863
- US-A- 4 322 692
- US-A- 4 816 782
- US-A- 5 126 699
- US-A- 5 151 668
- PATENT ABSTRACTS OF JAPAN vol. 018, no. 646 (E-1641), 8.Dezember 1994 & JP-A-06 252640 (FUJITSU LTD), 9.September 1994,
- PATENT ABSTRACTS OF JAPAN vol. 013, no. 330 (E-793), 25.Juli 1989 & JP-A-01 093205 (ALPS ELECTRIC CO LTD), 12.April 1989,

## Beschreibung

### Stand der Technik

Die Erfindung geht von einem spannungsgesteuerten Oszillator nach der Gattung des Hauptanspruchs aus.

Aus der EP 0 550 802 A1 ist ein spannungsgesteuerter Oszillator bekannt, bei dem ein aus einem einstellbaren Kondensator und einer Induktivität bestehender Schwingkreis über einen Kondensator und eine aus mindestens einer Schottky-Diode sowie mindestens einem Widerstand bestehende Diodenklemmschaltung mit dem Eingang (gate) eines in Drain-Schaltung arbeitenden Sperrschichtfeldeffekttransistors großer Steilheit verbunden ist, an dessen Drain-Elektrode eine positive Betriebsspannung parallel zu einer HF-Abblockkapazität liegt und dessen Ausgang über einen Widerstand mit einer Drossel sowie einem parallel dazu liegenden Kondensator und einem Widerstand verbunden ist. Die Mitkopplung des Sperrschichtfeldeffekttransistors als Verstärker des spannungsgesteuerten Oszillators erfolgt über eine zwischen Ausgang und Eingang des Verstärkers geschaltete Kapazität.

Eine aus der US-A-5 151 668 bekannte Schaltung hat den Vorteil, daß durch steuerbare Schalter der Verlauf des bei der Modulation mit einem NF-Signal entstehenden Frequenzhubes über die HF-Bandbreite des spannungsgesteuerten Oszillators linearisiert wird.

### Vorteile der Erfindung

Der erfindungsgemäße spannungsgesteuerte Oszillator mit den Merkmalen des Anspruchs 1 hat den besonderen Vorteil, daß durch die gegenphasige Einkopplung eines Teiles des NF-Signals in den Verstärker eine weitere Linearisierung des Verlaufes des Frequenzhubes über die HF-Bandbreite des spannungsgesteuerten Oszillators erfolgt.

Als weiterer Vorteil ist anzusehen, daß bei Verwendung mehrerer steuerbarer Schalter die Linearisierung des Frequenzhubes optimiert werden kann.

Durch die in den Unteransprüchen aufgeführten Maßnahmen sind vorteilhafte Weiterbildungen und Verbesserungen des im Hauptanspruch angegebenen spannungsgesteuerten Oszillators möglich. Besonders vorteilhaft ist, daß die Änderung der NF-Signalamplitude für den Frequenzhub auf einfache und wenig aufwendige Weise durch einen schaltbaren Spannungsteiler realisiert wird.

Vorteilhaft ist weiterhin, daß die beim Abgleich ermittelten Schaltfrequenzen in einem Speicher abgelegt und so dauerhaft verfügbar sind.

Als Vorteil ist auch anzusehen, daß die Betätigung des mindestens einen steuerbaren Schalters auf einfachen Vergleich der Frequenz des Oszillators mit den Schaltfrequenzen basiert und daher wenig Aufwand erfordert.

Vorteilhaft ist außerdem, daß der Benutzer die Frequenz des Oszillators und einzelne Schaltfrequenzen mittels einer Eingabeeinheit selbst vorgeben kann.

Bei Verwendung einer Kapazitätsdiode zur Einkopplung eines Teiles des NF-Signals in den Verstärker ergibt sich eine zusätzliche, vorteilhafte linearisierende Wirkung auf den Verlauf des Frequenzhubes.

### Zeichnung

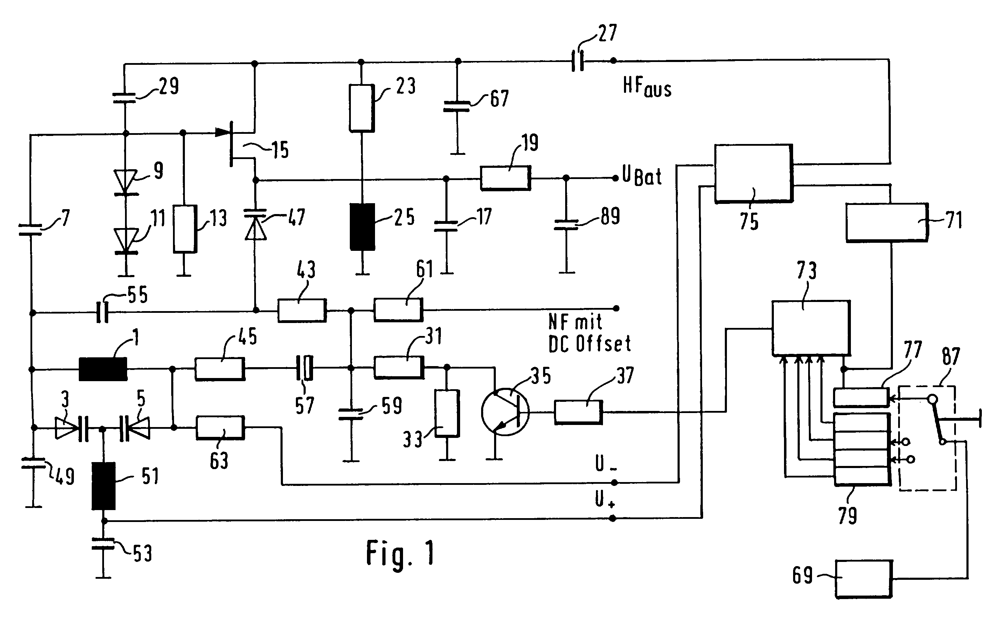

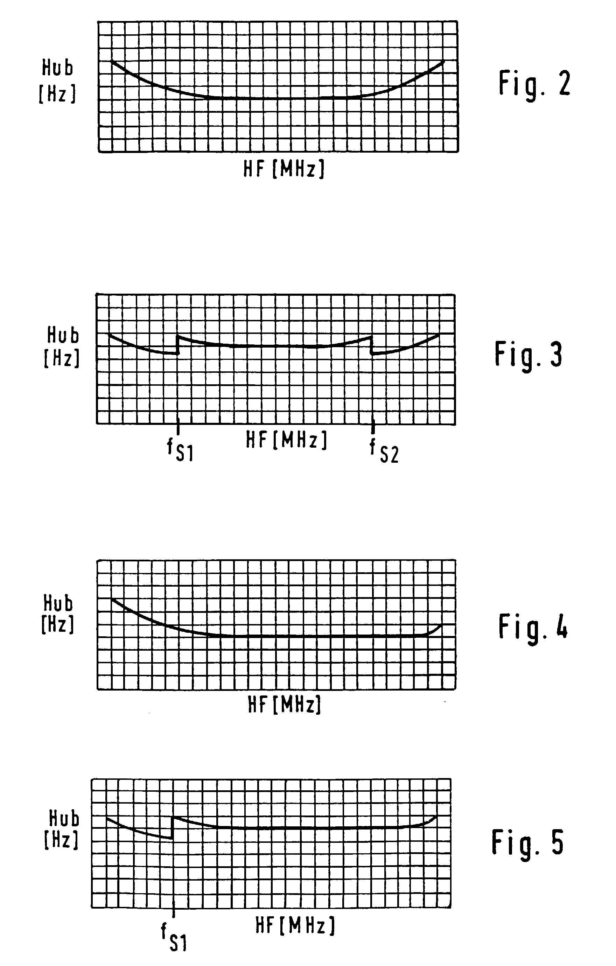

Ein Ausführungsbeispiel der Erfindung ist in der Zeichnung dargestellt und in der nachfolgenden Beschreibung näher erläutert. Es zeigen Figur 1 einen spannungsgesteuerten Oszillator, die Figuren 2 und 4 jeweils ein Beispiel für den Verlauf des Frequenzhubes über die HF-Bandbreite des spannungsgesteuerten Oszillators und die Figuren 3 und 5 den jeweils dazugehörigen und in einm bestimmten Frequenzbereich geänderten Verlauf des Frequenzhubes.

### Beschreibung des Ausführungsbeispiels

In Figur 1 kennzeichnen 3 und 5 eine erste und eine zweite Kapazitätsdiode im Gegentakt, deren Kathoden miteinander verbunden sind. Die beiden Kapazitätsdioden 3 und 5 bilden mit der parallel geschalteten Induktivität 1 einen Parallelschwingkreis, der über einen Kondensator 7 und eine aus zwei Schottky-Dioden 9 und 11 und einem dazu parallel liegenden Widerstand 13 bestehende Diodenklemmschaltung mit dem Eingang (gate) eines in Drain-Schaltung arbeitenden Sperrschichtfeldeffekttransistors 15 verbunden ist. Der Drain-Elektrode des Sperrschichtfeldeffekttransistors 15 ist eine Betriebsspannung U_{Bat} über ein Pi-Glied aus einem Strombegrenzungswiderstand 19 und zwei Kondensatoren 17 und 89 zur Abblockung des HF-Signals zugeführt. Der Ausgang (source) des Sperrschichtfeldeffekttransistors 15 ist über einen Widerstand 23 mit einer Drossel 25 sowie einem parallel dazu liegenden Kondensator 67, der zum Anschwingen des spannungsgesteuerten Oszillators benötigt wird, verbunden. Über einen weiteren mit dem Ausgang des Sperrschichtfeldeffektransistors 15 verbundenen Kondensator 27 wird das HF-Ausgangssignal HFₐᵤₛ ausgekoppelt. Der Sperrschichtfeldeffekttransistor 15 ist als Verstärker des spannungsgesteuerten Oszillators über einen zwischen dem Ausgang und dem Eingang des Verstärkers geschalteten Kondensator 29 mitgekoppelt.

Weiterhin werden über ein LC-Glied 51, 53 zur HF-Abblockung der gemeinsamen Kathode der ersten und der zweiten Kapazitätsdiode 3 und 5 eine positive Abstimmspannung U₊ und über einen Glättungswiderstand 63 der Anode der zweiten Kapazitätsdiode 5 eine negative Abstimmspannung U₋ zur Einstellung der Frequenz des spannungsgesteuerten Oszillators zugeführt. Ein durch die negative Abstimmspannung bewirkter Gleichspannungsanteil an der Anode der ersten Kapazitätsdiode 3 wird durch einen Kondensator 49 von der Masseleitung als Bezugspotential entkoppelt.

Die NF-Signalamplitude für den Frequenzhub ist einem Spannungsteiler aus einem ersten, einem zweiten und einem dritten Widerstand 61, 31 und 33 zugeführt, wobei der dritte Widerstand 33 über einen npn-Bipolartransistor 35 kurzschließbar ist, und weist einen positiven DC-Offset als Betriebsspannung für den npn-Bipolartransistor 35 auf. Der Teil des NF-Signals, der zwischen dem ersten und dem zweiten Widerstand 61 und 31 des Spannungsteilers anliegt, ist einem Kondensator 59 zur HF-Abblockung parallelgeschaltet und wird als modulierendes Signal über einen ersten Vorwiderstand 43 und einen ersten DC-Sperrkondensator 55 der Anode der ersten Kapazitätsdiode 3, über einen gepolten zweiten DC-Sperrkondensator 57 und einen zweiten Vorwiderstand 45 der Anode der zweiten Kapazitätsdiode 5 und über den ersten Vorwiderstand 43 und eine dritte Kapazitätsdiode 47 der Drain-Elektrode des Sperrschichtfeldeffekttransistors zugeführt.

Der npn-Bipolartransistor 35 ist über einen Basisvorwiderstand 37 mit einem Vergleicher 73 verbunden, dem der Wert der Frequenz des Oszillators aus einem ersten Speicher 77 und die Werte von 4 Schaltfrequenzen aus einem zweiten Speicher 79 zum Vergleich zugeführt sind. Der Wert der Frequenz des Oszillators ist außerdem einem weiteren Oszillator 71 zur Erzeugung eines entsprechend schwingenden Signals zugeführt. Dieses Signal wird zusammen mit dem HF-Ausgangssignal HFₐᵤₛ einem PLL-Baustein zugeführt, der wiederum die zur Regelung der gewünschten Frequenz des Oszillators notwendige positive und negative Abstimmspannung U₊ und U₋ abgibt.

Die Werte für zwei der vier Schaltfrequenzen und für die Frequenz des Oszillators lassen sich mittels einer Eingabeeinheit 69 eingeben. Über eine Schalteinrichtung 87 lassen sich die entsprechenden Speicherplätze des ersten und zweiten Speichers 77 und 79 mit der Eingabeeinheit 69 verbinden, so daß die Speicherplätze gegebenenfalls überschrieben werden können.

Der erste und der zweite Vorwiderstand 43 und 45 dienen der Aufteilung des modulierenden Signals auf die erste und die zweite Kapazitätsdiode 3 und 5 im Gegentakt. Die Wahl eines gepolten Kondensators für den zweiten DC-Sperrkondensator 57 ermöglicht eine große Kapazität bei kleiner Bauform und damit einen guten NF-Durchlaß. Der erste DC-Sperrkondensator 55 hingegen muß eine kleine Kapazität haben, um den Parallelschwingkreis nicht zu stark zu belasten. Die Belastung des Schwingkreises durch den zweiten DC-Sperrkondensators 57 wird durch die dämpfende Wirkung des zweiten Vorwiderstandes 45 verringert.

Die Einkopplung des modulierenden Signals auf den Schwingkreis führt zu einem mit der Frequenz des Oszillators ansteigenden Verlauf des Frequenzhubes über die HF-Bandbreite des spannungsgesteuerten Oszillators. Durch die gegenphasige Einkopplung des modulierenden Signals über den ersten Vorwiderstand 43 und die Kapazitätsdiode 47 in den Verstärker 15 findet eine Kompensation des Verlaufs des Frequenzhubes statt, der dann dem einer Schüssel ähnlich ist (Figur 2). Durch Bauteiltoleranzen kann sich die Lage der "Schüssel" verändern, d. h. die Schüssel kippt (Figur 4). Als Folge davon wird der Abstand der beiden Extremwerte des Frequenzhubes größer. Diese Hubüberhöhung kann am Bandanfang oder am Bandende auftreten. Zur weiteren Linearisierung des Verlaufes des Frequenzhubes sind eine untere und eine obere Schaltfrequenz f_{S1} und f_{S2} zum Anheben des Frequenzhubes vorgebbar. Beide Schaltfrequenzen sind in dem vorzugsweise als EEPROM ausgeführten zweiten Speicher 79 abgelegt und können nach ihrer Ermittlung in einem nur einmal notwendigen Abgleich über die Eingabeeinheit 69 und die Schalteinrichtung 87 in den entsprechenden Speicherplätzen abgelegt werden.

Die restlichen beiden Speicherplätze des zweiten Speichers 79 enthalten eine minimale und eine maximale Schaltfrequenz, wobei die minimale Schaltfrequenz kleiner als die untere und die maximale größer als die obere Bandgrenze des verwendeten Frequenzbandes ist, und können nicht überschrieben werden.

Solange die Frequenz des Oszillators größer als die minimale und kleiner als die untere vorgebbare Schaltfrequenz f_{S1} ist, gibt der Vergleicher 73 eine Steuerspannung auf die Basis des npn-Bipolartransistors 35, so daß er leitet und den dritten Widerstand 33 des Spannungsteilers kurzschließt. Überschreitet die Frequenz des Oszillators die untere vorgebbare Schaltfrequenz f_{S1}, dann verringert der Vergleicher 73 die Steuerspannung so, daß der npn-Bipolartransistor 35 sperrt. Daraus ergibt sich eine Änderung des Teilungsverhältnisses des Spannungsteilers und eine sprunghafte Erhöhung der Amplitude des modulierenden Signals, die sich in einer sprunghaften Erhöhung des Frequenzhubes äußert (Figur 3 und Figur 5). Bei Unterschreitung der unteren vorgebbaren Schaltfrequenz f_{S1} oder Überschreitung der oberen vorgebbaren Schaltfrequenz f_{S2} wird der npn-Bipolartransistor 35 wieder leitend und es ergibt sich eine sprunghafte Absenkung des Frequenzhubes. Bei Unterschreitung der oberen vorgebbaren Schaltfrequenz f_{S2} steigt der Frequenzhub entsprechend sprunghaft an. Wie in Figur 5 zu sehen ist, kann eine vorgebbare Schaltfrequenz auch außerhalb des dargestellten verwendeten Frequenzbandes liegen.

Eine Optimierung der Linearisierung des Verlaufes des Frequenzhubes läßt sich dadurch erreichen, daß dem Spannungsteiler weitere Widerstände hinzugefügt werden, die jeweils durch einen vom Vergleicher 73 angesteuerten Transistor kurzschließbar sind. Für jeden so hinzugefügten Widerstand läßt sich die Zahl der vorgebbaren Schaltfrequenzen verdoppeln. Dies erfordert auch eine entsprechende Erweiterung des zweiten Speichers 79.

## Patentansprüche

1. Spannungsgesteuerter Oszillator, der mittels mindestens einer Kapazitätsdiode (3, 5) in seiner Frequenz modulierbar ist, wobei mindestens ein steuerbarer Schalter (35) vorgesehen ist, der die NF-Signalamplitude für den Frequenzhub ändert und Mittel (73) vorgesehen sind, so daß der mindestens eine steuerbare Schalter (35) in Abhängigkeit von der Frequenz des Oszillators schaltet, dadurch gekennzeichnet, daß als verstärkendes aktives Element ein Verstärker (15) vorgesehen ist, in den ein Teil des NF-Signals zur Linearisierung des Hubes gegenphasig eingekoppelt ist.

2. Spannungsgesteuerter Oszillator nach Anspruch 1, dadurch gekennzeichnet, daß eine Kapazitätsdiode (47) zur gegenphasigen Einkopplung eines Teils des NF-Signals in den Verstärker (15) vorgesehen ist.

3. Spannungsgesteuerter Oszillator nach Anspruch 1 oder 2, dadurch gekennzeichnet, daß die NF-Signalamplitude einem Spannungsteiler (61, 31, 33) zugeführt ist, dessen Teilungsverhältnis durch den mindestens einen steuerbaren Schalter (35) änderbar ist.

4. Spannungsgesteuerter Oszillator nach Anspruch 1, 2 oder 3, dadurch gekennzeichnet, daß als steuerbarer Schalter (35) ein Transistor Verwendung findet.

5. Spannungsgesteuerter Oszillator nach einem der vorherigen Ansprüche, dadurch gekennzeichnet, daß ein Speicher (79) vorgesehen ist, in dem Schaltfrequenzen abgelegt sind, daß ein Vergleicher (73) vorgesehen ist, der die Frequenz des Oszillators mit den Schaltfrequenzen vergleicht, wobei eine Betätigung des steuerbaren Schalters (35) erfolgt, wenn die Frequenz die gespeicherte Schaltfrequenz überschreitet und/oder unterschreitet.

6. Spannungsgesteuerter Oszillator nach Anspruch 5, dadurch gekennzeichnet, daß der Speicher (79) als EEPROM ausgeführt ist.

7. Spannungsgesteuerter Oszillator nach einem der vorherigen Ansprüche, dadurch gekennzeichnet, daß die Frequenz des Oszillators mittels einer Eingabeeinheit (69) vorgebbar ist.

8. Spannungsgesteuerter Oszillator nach Anspruch 7, dadurch gekennzeichnet, daß einzelne Schaltfrequenzen mittels der Eingabeeinheit (69) vorgebbar sind.

## Claims

1. Voltage-controlled oscillator whose frequency can be modulated by means of at least one variable-capacitance diode (3, 5), where at least one controllable switch (35) is provided, which changes the AF signal amplitude for the frequency deviation, and means (73) are provided, so that the at least one controllable switch (35) switches as a function of the frequency of the oscillator, characterized in that an amplifier (15) is provided as amplifying active element, into which amplifier part of the AF signal is coupled in antiphase for the purpose of linearizing the deviation.

2. Voltage-controlled oscillator according to Claim 1, characterized in that provision is made of a variable-capacitance diode (47) for the in-antiphase coupling of part of the AF signal into the amplifier (15).

3. Voltage-controlled oscillator according to Claim 1 or 2, characterized in that the AF signal amplitude is fed to a voltage divider (61, 31, 33), whose division ratio can be changed by the at least one controllable switch (35) .

4. Voltage-controlled oscillator according to Claim 1, 2 or 3, characterized in that a transistor is used as controllable switch (35).

5. Voltage-controlled oscillator according to one of the preceding claims, characterized in that a memory (79) is provided, in which switching frequencies are stored, in that a comparator (73) is provided, which compares the frequency of the oscillator with the switching frequencies, the controllable switch (35) being actuated if the frequency exceeds and/or falls below the stored switching frequency.

6. Voltage-controlled oscillator according to Claim 5, characterized in that the memory (79) is designed as an EEPROM.

7. Voltage-controlled oscillator according to one of the preceding claims, characterized in that the frequency of the oscillator can be predetermined by means of an input unit (69).

8. Voltage-controlled oscillator according to Claim 7, characterized in that individual switching frequencies can be predetermined by means of the input unit (69).

## Revendications

1. Oscillateur commandé en tension, de fréquence modulable par au moins une diode capacitive (3, 5), comprenant,
- au moins un commutateur commandé (35) qui modifie l'amplitude du signal (BF) pour l'excursion de fréquence et,
- des moyens (73) pour commuter au moins un commutateur commandé (35) en fonction de la fréquence de l'oscillateur,
caractérisé en ce que
l'élément actif d'amplification est un amplificateur (15) dans lequel est injectée, en opposition de phase, une partie du signal BF pour linéariser l'excursion de fréquence.

2. Oscillateur commandé en tension selon la revendication 1,
caractérisé par
une diode capacitive (47) pour injecter en opposition de phase, une partie du signal BF dans l'amplificateur (15).

3. Oscillateur commandé en tension selon les revendications 1 ou 2,
caractérisé en ce que
l'amplitude du signal BF est appliquée par un diviseur de tension (61, 31, 33) dont le rapport de division est modifiable par au moins un commutateur commandé (35).

4. Oscillateur commandé en tension selon les revendications 1, 2, 3,
caractérisé en ce que
le commutateur commandé (35) est un transistor.

5. Oscillateur commandé en tension selon l'une des revendications précédentes,
caractérisé par
une mémoire (79) dans laquelle sont enregistrées les fréquences de commutation, et un comparateur (73) qui compare la fréquence de l'oscillateur aux fréquences de commutation, le commutateur commandé (35) étant actionné si la fréquence dépasse vers le haut ou vers le bas la fréquence de commutation enregistrée.

6. Oscillateur commandé en tension selon la revendication 5,
caractérisé en ce que
la mémoire (79) est une mémoire EEPROM.

7. Oscillateur commandé en tension selon l'une des revendications précédentes,
caractérisé en ce que
la fréquence de l'oscillateur est prédéterminée par une unité d'entrée (69) .

8. Oscillateur commandé en tension selon la revendication 7,
caractérisé en ce que
les diverses fréquences de commutation sont prédéterminées par l'unité d'entrée (69).
